Europäisches Patentamt

European Patent Office

Office européen des brevets

(11) Publication number: **0 354 195**
**A2**

# EUROPEAN PATENT APPLICATION

(21) Application number: 89830354.0

(22) Date of filing: 31.07.89

(51) Int. Cl.5: **G 02 B 5/08**
**H 01 S 3/08**

(30) Priority: 03.08.88 IT 4826588

(43) Date of publication of application:
07.02.90 Bulletin 90/06

(84) Designated Contracting States: **CH DE FR GB LI**

(71) Applicant: **ENEA COMITATO NAZIONALE PER LA RICERCA E PER LO SVILUPPO DEL L'ENERGIA NUCLEARE E DELLE ENERGIE ALTERNATIVE**
Viale Regina Margherita 125
I-00198 Roma (IT)

(72) Inventor: Emiliani, Gabriele c/o Enea
V. le Regina Margherita 125
I-00198 Rome (IT)

Piegari, Angela c/o Enea
V. le Regina Margherita 125
I-00198 Rome (IT)

(74) Representative: de Simone, Domenico et al
Ing. Barzanò & Zanardo Roma S.p.A. Via Piemonte 26
I-00187 Roma (IT)

(54) **Method for producing laser mirrors with radially variable reflectance.**

(57) A method for producing laser mirrors with radially variable reflectance in which one or more films of an optical material are deposited under vacuum onto a suitable substrate, said films having a thickness which varies along the radius according to a given law, in which method a mask is interposed between the deposition apparatus source and the substrate (11); the mask (13) shows one or more radial slits, whose transverse width varies as a function of the radius according to a given law, suitable for the desired thickness profile, the substrate (11) and the mask (13) being in rotation relatively to each other during the deposition.

*Fig. 3*

Description

## METHOD FOR PRODUCING LASER MIRRORS WITH RADIALLY VARIABLE REFLECTANCE

The present invention relates to a method for producing laser mirrors with radially variable refectance.

More particularly, this invention relates to a method for depositing films of an optical material onto substrates suitable for laser mirrors, which method provides films whose thickness varies along the radius of the mirror according to a given law, giving the mirror a reflectance which also varies radially according to a given law.

Some years since, considerable advantages have been found in the manufacturing of laser sources in which one of the mirrors of the cavity has a reflectance which gradually decreases from a maximum at the mirror center down to a zero value at the periphery of the same.

The sources designed with mirrors which have such a characteristic exhibit very good properties as regards output beam quality and efficiency.

Several solutions have been suggested and carried out for obtaining mirrors showing the aforesaid characteristics.

Moreover, the use has been suggested of an optical device obtained by coupling a plane mirror to a convex one, in order to take advantage of the interferential effect occurring along the path of the light ray due to the different values of the air space between the plane surface and the convex one, depending on the distance from the center.

This solution, however, shows considerable disadvantages, related to the complexity of the mechanical system which holds the two optical components coupled in the correct operating position, which position must be kept unaltered, in spite of the considerable thermal shocks caused by the operation at high power levels.

A different class of optical components for lasers which exhibits the aforesaid characteristic is the one which takes advantage of the known property of one or more thin films (made of suitable transparent dielectric materials, such as oxides of various kinds) deposited onto a suitable substrate (such as glass or other dielectric material) in order to obtain, by interferential effect, a suitable reflectance value. Since, as is known, this reflectance value is related to the thickness of the films themselves, it is apparent that a point to point variable reflectance value will be obtained if one succeeds in obtaining a suitable distribution of the thickness of one or more of the deposited films.

The problem concerns thus the execution of a deposition of one or more layers of an optical material onto a suitable substrate, so as to obtain a thickness profile showing the desired value as a function depending on the distance from the center.

In order to achieve this result, a method has been suggested for depositing films which consists in interposing a mask, endowed with a circular hole of a suitable diameter, between the cathod source and the substrate inside a sputtering deposition apparatus, with the mask being positioned at a well determined distance from the substrate surface.

The shading effect, due to the diffusion of the material which deposits, yields a thickness profile which gradually decreases from the substrate center to the periphery.

By conveniently selecting the diameter of the mask hole and the distance of the mask from the substrate, various shapes of the thickness profile are afforded which have also been interpreted by a mathematical model. This model allows, within certain limits, the correct selection of the parameters to be obtained, in order to realize the desired profile.

This solution also is not, however, free from drawbacks, as its applicability is limited within a restricted range of mirror sizes and reflectance profiles, with a not always satisfactory approximation.

Also, the shape of the profile which has been obtained depends on the geometrical pattern of the deposition apparatus (cathod source diameter, distance of the mask from the source, etc.).

The present invention aims at overcoming the aforesaid drawbacks, by providing a method for depositing an optical material onto laser mirror substrates, which method allows thickness to be obtained which vary according to a given law as a function of the radius, with a high precision and a high repeatabil ity, and without mirror size limitations.

A further object of the present invention is to provide a method which may ensure results wholly independent of the geometrical structure of the vapourization apparatus and of the vacuum deposition technique specifically adopted.

The aforesaid objects are achieved by a method which is the subject of the present invention, which essentially consists in carrying out the deposition of the optical material by one of the known techniques, while superimposing on the substrate a mask rotating relatively to the substrate itself, in which mask one or more radial slits are provided of a suitable radially variable width. The width of said slits is computed on a point to point basis such that, as the mask rotates relatively to the substrate during the deposition, each point on the surface of the substrate is exposed for a total time such as to cause the desired thickness to be obtained at that point, said total time being dependent on the distance of the point from the center.

It is indeed apparent that if the substrate and the mask are rotating relatively to each other, the longer the circle arc left uncovered by the slit at a determined radius r, the longer the deposition time for which all the points of the substrate are exposed on the circle having that radius.

It is also apparent that for the same slit width the exposition time is anyway decreasing with r increasing, because of the tangential speed of the points of the substrate with respect to the mask, which in creases with the distance from the center.

In practice, for instance, with a uniform rotatory relative motion, as the tangential speed is proportional to r, to obtain a film thickness uniformly deposited along the radius, the radial slit must be in the shape of a circular sector, i.e. the arcs left uncovered by the slit must increase proportionally to the radius.

Starting from the desired reflectance profile, and thus from the desired thickness profile, each arc of aperture of the slit will be so long correspondingly to each point of the radius, as to make the exposition time proportional to the thickness desired at that point, taking into account the tangential speed at that point.

By suitably designing the slit profile, it is thus possible to obtain a variation of the thickness profile according to any desired law along the radius.

Therefore, the present invention specifically provides a method for producing laser mirrors with radially variable reflectance, in which one or more films of an optical material are vacuum deposited under vacuum onto a suitable substrate, said films having a thickness which varies along the radius according to a given law, said method being characterized in that a mask is interposed between the substrate and the source of the deposition apparatus, the mask being endowed with one or more radial slits or lobes whose transverse width is a function of the radius according to a given law, such that as said substrate and mask are rotating relatively to each other while depositing, the total ex position time of each point of the surface of the substrate varies according to a given law depending on the distance from the center, said law being related to the desired thickness profile of the film or of the films of optical material, and thus being related to the reflectance profile.

For uniformity and efficiency purposes, the aforesaid shaped radial slit may be reproduced two or many times on the mask, symmetrically about the center.

Preferably, the mask is kept fixed on the support, while the substrate, during the deposition, spins about its central axis which lies at right angles with respect to the plane of the surface to be coated.

In order to center the mask with respect to the spin axis of the substrate, a centering member is preferably adopted, endowed with centering pins, sized likewise the substrate. Before starting the deposition, the centering member is located instead of the substrate and the suitable holes provided on the mask are coupled to said centering pins; then the mask is rigidly affixed to the support in the resulting position.

As previously described, the advantages shown by the method of the present invention consist first in the fact that the method itself is independent of the geometric characteristics of the deposition apparatus, and generally of the adopted deposition technique, and in the fact that mirrors can be produced of any size and of any thickness profile, and, also, in a high precision and in a high repeatability.

However, it is to be taken into account that the deposition rate inside a vacuum apparatus is not perfectly uniform for all the points of the exposed surface. This could thus cause the obtained thickness profile to deviate from the desired one.

Also the effects due to an even small distance of the mask from the substrate surface, or due to phenomena related to the spinning, can cause the deposition to be irregular.

In order to take into account these factors it is suggested, when calculating at each point the transverse width of the radial slits, to include a correction factor resulting from a previous calibration operation.

Said operation is carried out by applying the method of the present invention to a sample, with a mask having radial slits of a very simple shape and such that the resultant thickness profile follows a given law, which is itself very simple. The preferred calibration shape for the slits is obviously the circular sector, which, as previously observed, causes the thickness distribution to be uniform.

By applying the method with the calibration mask, the thickness deviations are determined with respect to the theoretical values and a calibration curve is obtained as a function of the radius.

When calculating the slit width at each point, a correction factor, obtained from said calibration curve, will be taken into account.

The present invention will be disclosed in the following just for illustrative and not for limitative purposes, with reference to a specific embodiment there of which is illustrated in the figures of the accompanying drawings, wherein:

Figure 1 shows a typical desired reflectance profile;

Figure 2 shows the corresponding thickness profile;

Figure 3 shows a schematic side view partially in section of a mechanical assembly by which the method of the present invention is carried out;

Figure 4 shows a side view of a centering member,

Figure 5 shows a calibration mask, and

Figure 6 shows a mask suitable to give the thickness the profile of Figure 2.

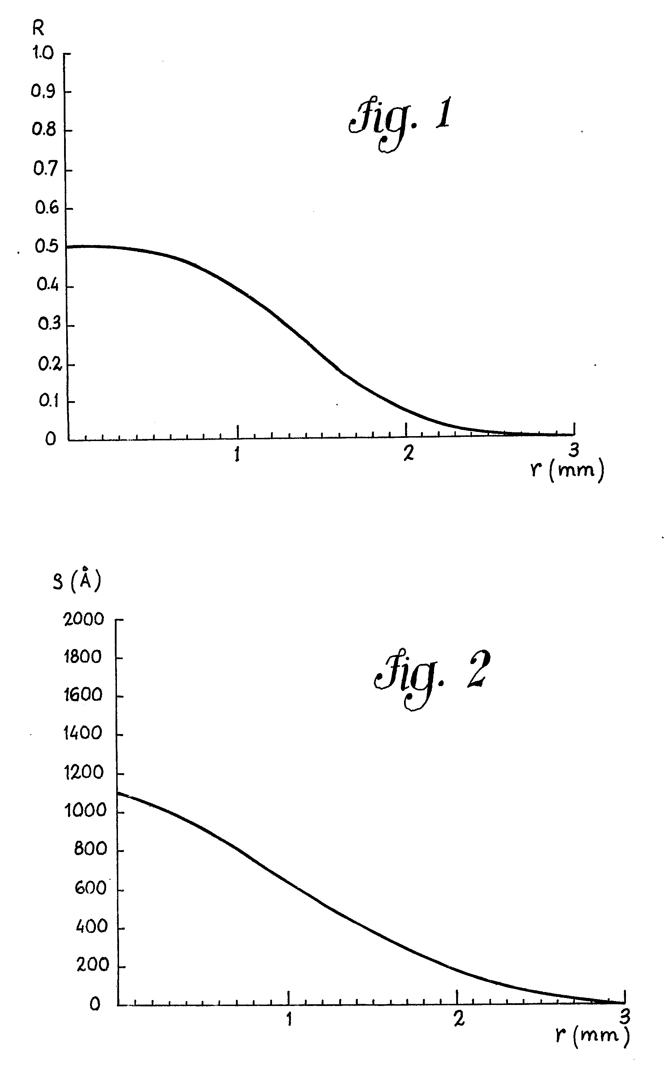

The diagram of Figure 1 shows a radially variable reflectance comparative profile, such as may be needed for a laser cavity mirror.

The equation which represents this type of curve is:

$$R = R_0 \exp[-2(r/w)^n]$$

where R is the reflectance depending on the radius r, n is the exponent of the Gauss curve, w (spot size) corresponds to the radius at which the reflectance reduces to $(I/e)^2$ of the mirror reflectance at the center, $R_0$.

The $R_0$ value is determined from the film thickness which can be obtained at the mirror center by operating on the deposition time of the film itself.

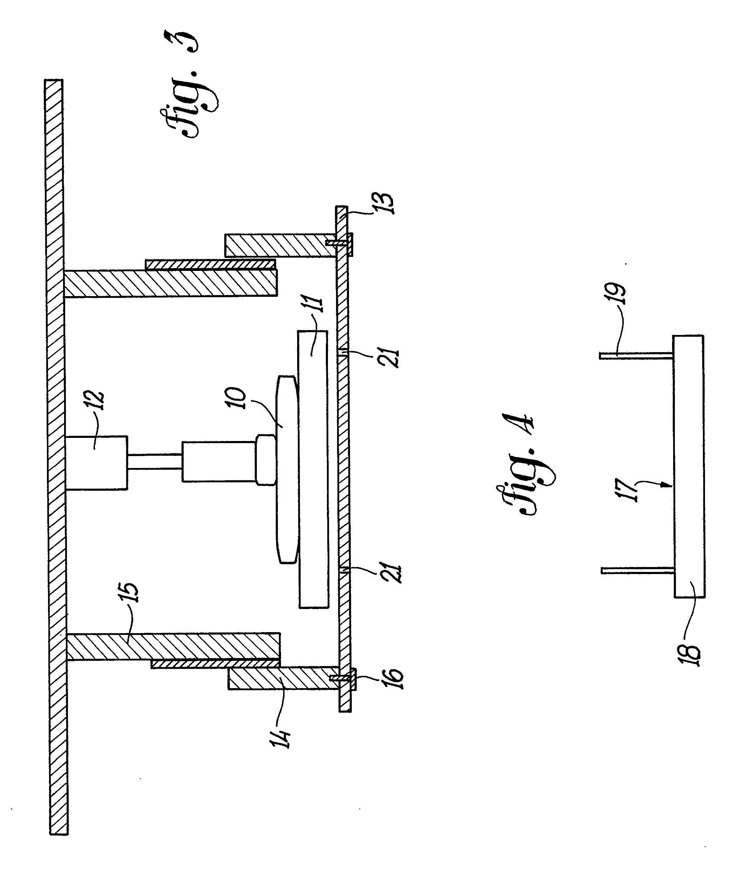

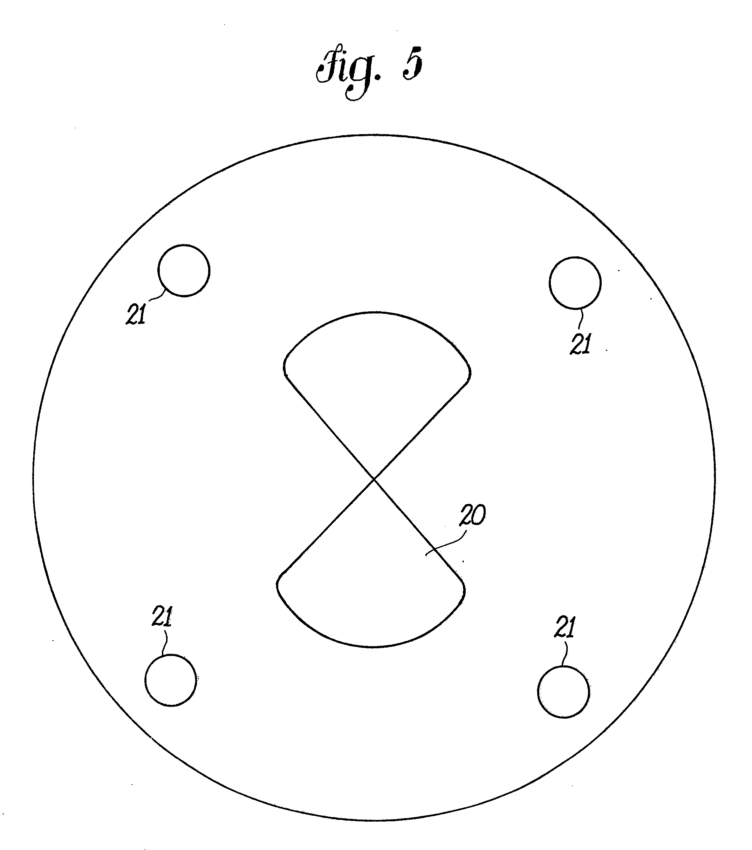

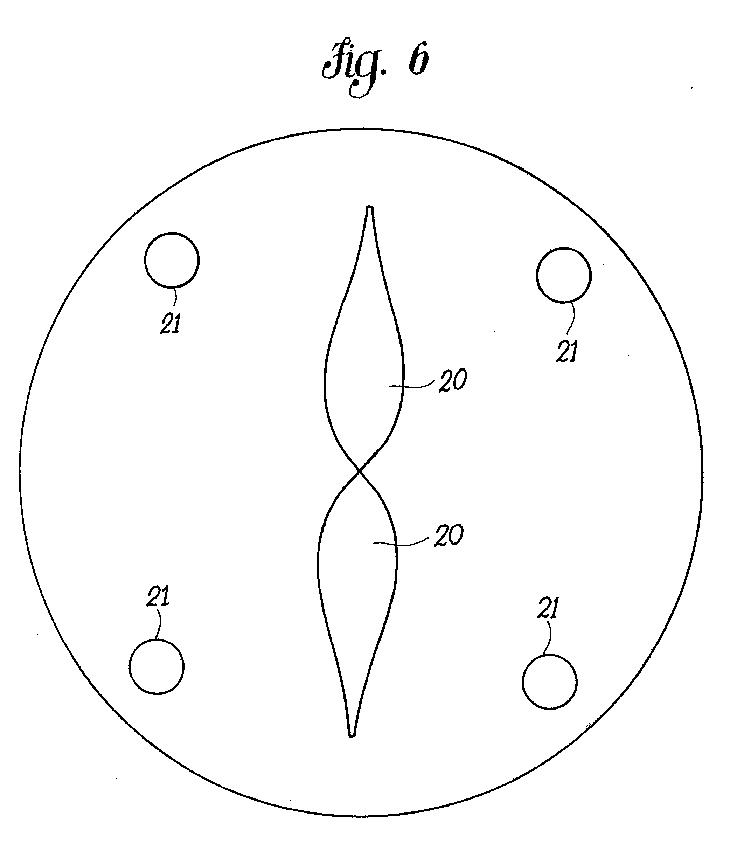

As previously said, the thickness distribution illustrated in Figure 2 corresponds to the radial distrib ution of the reflectance in Figure 1. The former can be obtained, according to the method of the present invention, by utilizing a mask whose slits 20 show the shape specifically illustrated in Figure 5.

In Figure 3, for illustrative purposes, an assembly is shown which allows the method of this invention to be carried out.

The reference 10 indicates the support member of the substrate 11, which is caused to spin by means of a motor 12.

The mask 13, which is of the kind shown in Figures 5 and 6, is fixed, lying on the support 14, which in turn is affixed to the base 15 by means of a thread which allows the height to be so adjusted as to bring the mask as close as possible to the surface of the substrate 11.

The coupling of the mask 13 to the support 14 is obtained by means of fastening elements 16, after that the mask itself has been properly centered with respect to the rotation axis of the substrate. The centering is carried out by utilizing the centering member of Figure 3.

This member is comprised of a metallic member 18 having the same dimensions as the substrate and is endowed with four centering pins 19 arranged at the four centering holes 21 provided on the mask (see Figures 5 and 6).

The centering operation is carried out by arranging the centering member 17 instead of the substrate on the support 10 and by arranging the mask on the support 14 without tightening the fastening elements 16.

Then the mask support 14 is screwed on its base until the centering holes 21 of the mask are allowed to coincide with the four pins 19 of the centering member.

At this point, the mask is rigidly affixed to the support 14 by means of the fastening elements 16 and the centering device 17 is taken away to allow the substrate 11 to be definitively positioned.

After the vacuum has been made within the apparatus, the substrate is caused to spin and the film deposition operation is carried out.

Conventional checking systems, such as a quartz balance, can be utilized to verify the maximum thickness desired at the substrate center, the checking system having been previously calibrated.

As previously observed, the shape of the slits 20 of the mask, e.g. the mask of Figures, is determined by point to point describing circle arcs from the mask center, said circle arcs having a length which, divided by the tangential rotation speed at each point, determine a substrate exposition time proportional to the thickness desired at that point.

The length calculated in such a way is preferably adjusted to take into account the deviations from the theoretic value observed while calibrating, by introducing a multiplicative correction factor derived from the calibration curve.

This calibration curve is obtained in the aforesaid way by previously applying the method to a sample, for instance by employing the calibration mask shown in Figure 4.

Both masks (Figures 5 and 6) show centering holes 21 in addition to the slits or lobes 20, which centering holes correspond to the pins 19 of the centering member 17.

## Claims

1. A method for producing laser mirrors with radially variable reflectance, in which one or more films of an optical material are deposited under vacuum onto a suitable substrate, said films having a thickness which varies along the radius according to a given law, said method being characterized in that a mask is interposed between the substrate and the source of the deposition apparatus, the mask being endowed with one or more radial slits, whose transverse width is a function of the radius according to a given law, such that, as said substrate and said mask are rotating relatively to each other during the deposition, the total exposition time of each point on the surface of the substrate varies according to a given law depending on the distance from the center, said law being related to the desired thickness profile of the film or of the films of optical material, and thus being related to the reflectance profile.

2. A method according to claim 1, in which said mask is fixed to a support, and said support, during the deposition, is rotating about a central axis which lies at right angles with respect to the plane of the surface to be coated.

3. A method according to claim 1 or 2 in which said mask shows two of the said radial slits, which are radially aligned.

4. A method according to claim 2 or 3 in which before the deposition said mask is centered with respect to the spin axis of said support by means of a centering member with substantially the same dimensions as said substrate and endowed with centering pins which correspond to some holes provided on the mask, by arranging said member instead of the substrate, coupling said pins to said holes and affixing said mask in the resultant position.

5. A method according to each one of claims 1-4, in which the transverse width of said one or more radial slits, determined from the desired thickness profile and from the tangential speed at each radial point, is further corrected by taking into account the shifts from the theoretic thicknesses, determined by a previous calibration operation.

6. A method according to claim 5, in which said calibration is carried out by applying the method of the claims 1-4 to a sample, with one of said masks showing radial slits so shaped as to cause the corresponding thickness profile to follow a known law, and by point to point determining the shifts of the resultant thicknesses from the theoretic values of the same.

7. A method according to claim 6, in which said calibration mask shows one or more radial slits in the shape of circular sectors, the corresponding thickness profile being uniform on all the surface of said substrate.

EP 0 354 195 A2

Fig. 1

Fig. 2

fig. 3

fig. 4

# fig. 5

*Fig. 6*